# EUROPEAN PATENT SPECIFICATION

(11) **EP 3 299 876 B1**
(45) Date of publication and mention of the grant of the patent: **15.04.2020**
(21) Application number: 17192534.0
(22) Date of filing: 22.09.2017
(51) Int. Cl.: G02F 1/1333

(54) **DISPLAY DEVICE AND METHOD OF MANUFACTURING THE SAME**
ANZEIGEVORRICHTUNG UND VERFAHREN ZUR HERSTELLUNG DAVON
AFFICHEUR ET SON PROCÉDÉ DE FABRICATION

(30) Priority: 23.09.2016 KR 20160122057
(43) Date of publication of application: 28.03.2018
(73) Proprietor: Samsung Display Co., Ltd., Gyeonggi-do 17113 (KR)
(72) Inventor: Kim, Taesik, Seongnam-si, Gyeonggi-do 112-1401 (KR); Park, Chunseong, Chungcheongnam-do (Yojin Y-city), 31471, Korea 107-2602 (KR); So, Kyoungsub, 31099, Korea 103-2103 (KR); Lee, Kyungsu, 18396, Korea 101-1503 (KR); Choi, Daeguen, 31101, Korea 102-502 (KR)
(74) Representative: Dr. Weitzel & Partner

(56) References cited:
- US-A- 4 808 639
- US-A1- 2006 078 741
- US-A1- 2015 153 609
- US-A1- 2016 116 789

## Description

### BACKGROUND

### 1. Field

Embodiments of the present invention relate to a display device including an adhesive member for fixing a window and a display module, and to a method of manufacturing the display device.

### 2. Discussion of Related Art

Display devices may be classified into liquid crystal display ("LCD") devices, organic light emitting diode ("OLED") display devices, plasma display panel ("PDP") devices, electrophoretic display devices, and the like based on a light emitting scheme thereof.

Such a display device includes a display module, and a support frame for supporting and fastening the display module. To reduce the thickness of the display device, the display module is directly attached to the support frame using an adhesive member. The adhesive member is cured to attach the display module and the support frame to each other. A similar display device is disclosed in document US 2017/0116789 A1. In the case where the curing of the adhesive member is not sufficiently advanced, the display module may be detached from the support frame.

A pressure-sensitive adhesive composition which may be used in the preparation of such an adhesive member is disclosed in document US 4,808,639.

It is to be understood that this background section is intended to provide useful background for understanding the technology, and may include ideas, concepts or recognitions that were not part of what was known or appreciated by those skilled in the pertinent art prior to a corresponding effective filing date of subject matter disclosed herein.

### SUMMARY

Embodiments of the present invention may be directed to a display device capable of stably fixing a display module, a support frame, and a window, and to improving defective adhesion otherwise caused by bubbles.

According to an embodiment, a display device includes a support frame having an accommodation space, a display module in the accommodation space, a window on the display module, and having a transmissive area and a non-transmissive area, a light-blocking layer at the non-transmissive area of the window, and an adhesive member between the light-blocking layer and the support frame, and including an adhesive polymer matrix, a ruptured shell structure, and an exothermic curing agent, wherein the window is attached to the support frame by the adhesive member. The adhesive polymer matrix includes an adhesive polymer resin, a monomer, and a curing accelerator. The window may be also called a window member or transparent member.

The ruptured shell structure may include at least one of a melamine resin, a urethane resin, an acrylic resin, a urethane acrylic resin, and an epoxy resin.

The exothermic curing agent may include one of diethylenetriamine (DETA), triethylenetetramine (TTA), tetraethylenepentamine (TEPA), diproprenediamine (DPDA), diethylaminopropylamine (DEAPA), methane diamine (MDA), isophoronediamine (IPDA), metaphenylene diamine (MPDA), diaminodiphenylmethane (DDM), and diaminodiphenylsulfone (DDS).

The curing accelerator may include at least one of piperidine, dimethyl-piperidine, triethylenediamine, benzyl dimethylamine, 2-(dimethyl aminomethyl) phenol, and 2,4,6-tri (dimethylamino methylphenol).

The adhesive member may further include a shell, and wherein the exothermic curing agent is accommodated in the shell.

The display module may include a display panel.

The display panel may include a first substrate, a second substrate opposing the first substrate, and a liquid crystal layer between the first substrate and the second substrate.

The display panel may include a first substrate, a first electrode on the first substrate, an organic light emitting layer on the first electrode, and a second electrode on the organic light emitting layer.

The display module may include a touch sensor unit on the display panel.

According to an embodiment, a method of manufacturing a display device includes providing a light-blocking layer on one surface of a window having a transmissive area and a non-transmissive area, providing an adhesive member on the light-blocking layer, attaching the window, on which the adhesive member is located, and a support frame accommodating a display module, and applying a pressure to the window and the support frame.

The adhesive member includes an adhesive polymer matrix, a shell dispersed in the adhesive polymer matrix, and an exothermic curing agent accommodated in the shell. The adhesive polymer matrix includes an adhesive polymer resin, a monomer, and a curing accelerator.

The shell may include at least one of diethylenetriamine (DETA), triethylenetetramine (TTA), tetraethylenepentamine (TEPA), diproprenediamine (DPDA), diethylaminopropylamine (DEAPA), methane diamine (MDA), isophoronediamine (IPDA), metaphenylene diamine (MPDA), diaminodiphenylmethane (DDM) and diaminodiphenylsulfone (DDS).

The pressure may be in a range from about 3 kgf/m² (29,42 Pa) to about 10 kgf/ m² (98,07 Pa).

The method may further include rupturing the shell is by the pressure.

The foregoing is illustrative only and is not intended to be in any way limiting. In addition to the illustrative aspects, embodiments and features described above, further aspects, embodiments and features will become apparent by reference to the drawings and the following detailed description.

### BRIEF DESCRIPTION OF THE DRAWINGS

A more complete appreciation of the present invention will become more apparent by describing in detail embodiments thereof with reference to the accompanying drawings, wherein:
FIG. 1 is a perspective view illustrating a display device according to an embodiment;
FIG. 2 is a cross-sectional view illustrating the display device taken along the line I-I' of FIG. 1;
FIG. 3 is a cross-sectional view illustrating an adhesive member according to an embodiment;
FIGS. 4A, 4B and 4C are views illustrating a method of manufacturing a display device according to an embodiment;
FIGS. 5A, 5B, 5C and 5D are views illustrating a process of curing an adhesive member according to an embodiment;
FIG. 6 is a view illustrating a shell and an exothermic curing agent according to an embodiment;
FIG. 7 is a plan view illustrating a display area of an organic light emitting diode ("OLED") display panel according to an alternative embodiment;
FIG. 8 is a cross-sectional view taken along the line II-II' of FIG. 7;
FIG. 9 is a plan view illustrating a display area of a liquid crystal display ("LCD") panel according to another alternative embodiment; and
FIG. 10 is a cross-sectional view taken along the line III-III' of FIG. 9.

### DETAILED DESCRIPTION

Features of the inventive concept and methods of accomplishing the same may be understood more readily by reference to the following detailed description of embodiments and the accompanying drawings. Hereinafter, embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

In the following description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form in order to avoid unnecessarily obscuring various embodiments.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present invention.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that when an element, layer, region, or component is referred to as being "on," "connected to," or "coupled to" another element, layer, region, or component, it can be directly on, connected to, or coupled to the other element, layer, region, or component, or one or more intervening elements, layers, regions, or components may be present. However, "directly connected/directly coupled" refers to one component directly connecting or coupling another component without an intermediate component. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," when preceding a list of elements, modify the entire list of elements and do not modify the individual elements of the list. For example, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. Like numbers refer to like elements throughout. As used herein, the term "and/or" includes any and all combinations of one or more of the associated listed items.

In the following examples, the x-axis, the y-axis and the z-axis are not limited to three axes of a rectangular coordinate system, and may be interpreted in a broader sense. For example, the x-axis, the y-axis, and the z-axis may be perpendicular to one another, or may represent different directions that are not perpendicular to one another.

The terminology used herein is for the purpose of describing particular embodiments only and is not intended to be limiting of the present invention. As used herein, the singular forms "a" and "an" are intended to include the plural forms as well, unless the context clearly indicates otherwise. It will be further understood that the terms "comprises," "comprising," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present invention refers to "one or more embodiments of the present invention." As used herein, the terms "use," "using," and "used" may be considered synonymous with the terms "utilize," "utilizing," and "utilized," respectively. Also, the term "exemplary" is intended to refer to an example or illustration.

When a certain embodiment may be implemented differently, a specific process order may be performed differently from the described order. For example, two consecutively described processes may be performed substantially at the same time or performed in an order opposite to the described order.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not be construed as limited to the particular illustrated shapes of regions, but are to include deviations in shapes that result from, for instance, manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

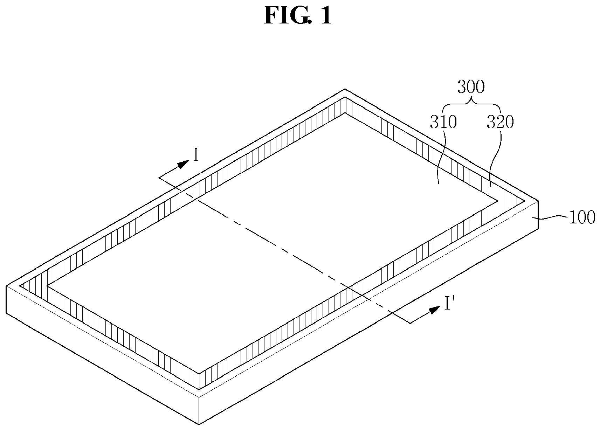

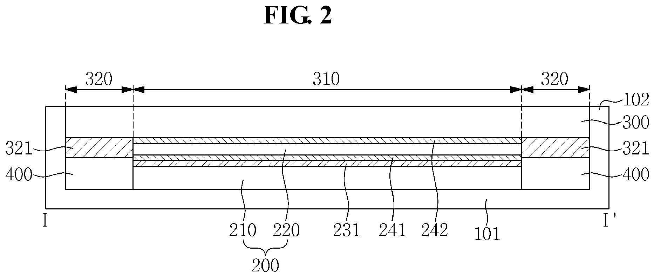

FIG. 1 is a perspective view illustrating a display device according to an embodiment, and FIG. 2 is a cross-sectional view illustrating a display device taken along the line I-I' of FIG. 1.

A display device according to an embodiment will be described with reference to FIGS. 1 and 2. Referring to FIGS. 1 and 2, a display device includes a support frame 100, a display module 200, a window 300, a light-blocking layer 321 and an adhesive member 400.

The support frame 100 includes a planar surface portion 101 supporting the display module 200 to be described below, and also includes a side wall portion 102 bent from the planar surface portion 101. The support frame 100 has an accommodation space defined by the planar surface portion 101 and the side wall portion 102. The display module 200 is stored in the accommodation space.

The support frame 100 may include a metal material having excellent rigidity and heat dissipation characteristics. For example, the support frame 100 may include at least one selected from the group consisting of stainless steel, aluminum, an aluminum alloy, magnesium, a magnesium alloy, copper, a copper alloy and an electrogalvanized steel sheet. However, embodiments are not limited thereto, and the support frame 100 may include a material having flexible characteristics.

As illustrated in FIGS. 1 and 2, the display module 200 is located in the accommodation space defined by the support frame 100. The display module 200 includes a display panel 210 and a touch sensor unit 220.

The display panel 210 displays an image. The display panel 210 may be a light receiving type display panel, and may include an LCD panel, an electro-wetting display panel, an electrophoretic display panel, a microelectromechanical system ("MEMS") display panel, and the like. In an embodiment, the display panel 210 may be a flexible panel that may be bent in at least one direction.

The display panel 210 may have, on a plane, a display area for displaying an image, and a non-display area fully or at least partially surrounding the display area and displaying no image.

The display panel 210 may have a quadrangular plate shape having two pairs of respectively parallel sides. The display panel 210 may be a rectangle having a pair of long sides and a pair of short sides. However, embodiments are not limited thereto, and the display panel 210 may have various shapes.

As illustrated in FIG. 2, a polarizing member 231 may be on the display panel 210. The polarizing member 231 may be on the display panel 210 so as to cover at least a part of the display panel 210. Alternatively, the polarizing member 231 may be formed to have a substantially same size as a size of the display panel 210 so as to cover an entire surface of the display panel 210. The polarizing member 231 may have a single layer or a plurality of layers including a polarizing film and a retardation film.

The touch sensor unit 220 may be on the display panel 210. The touch sensor unit 220 may be an input means for the display device, and may be configured as a pressure sensitive type or a capacitive type. The touch sensor unit 220 may have a structure in which a plurality of sensing electrodes are on a separate substrate. However, embodiments are not limited thereto, and the touch sensor unit 220 may be an on-cell type that is directly on the display panel 210 without a separate substrate, or may be an in-cell type that is formed in the display panel 210.

The display module 200 may further include a driving unit. The driving unit may include a display panel driving unit and a touch sensor unit driving unit.

The display panel driving unit may further include a scan driver and a data driver for driving the display panel. In addition, the display panel driving unit may further include pad electrodes in the non-display area. The display panel driving unit may be mounted at the non-display area of the display panel 210 in a chip on glass (COG) manner so as to be electrically connected to the pad electrode. In such an embodiment, the display panel 210 may further include wirings connecting the scan driver and the data driver to each other. In an embodiment, the display panel driving unit is not necessarily formed in the non-display area, and may be omitted. A buffering member for protecting the display panel driving unit from an external impact may be further located in the non-display area. The display panel driving unit may be a driving integrated circuit ("IC").

The touch sensor unit driving unit may receive a signal, which corresponds to a position where a touch action is performed by touch means (e.g., a pen or a user's finger), from the touch sensor unit 220 that recognizes the touch.

The window 300 is on the display module 200 so as to protect the display module 200 from external scratches.

The window 300 includes a transmissive area 310 and a non-transmissive area 320. For example, the non-transmissive area 320 surrounds the transmissive area 310, and may be positioned at an edge of the window 300.

The window 300 may include any one selected from the group consisting of glass, sapphire, diamond, polymethylmethacrylate (PMMA) and polycarbonate (PC). Accordingly, an image generated in the display module 200 may be transmitted to the user through the transmissive area 310 of the window 300.

The window 300 may have a quadrangular plate shape having two pairs of respectively parallel sides. The window 300 may be a rectangle having a pair of long sides and a pair of short sides. However, embodiments are not limited thereto, and the window 300 may have various shapes.

A hard coating layer or a protective layer may be on the window 300. The hard coating layer may include an acrylate-based monomer or an inorganic chemical compound. The hard coating layer serves to enhance surface hardness and chemical-resistance characteristics of the window 300.

A protective layer may be on the hard coating layer. The protective layer may be a functional coating layer including an anti-finger (AF) coating layer, an antireflection (AR) coating layer, an anti-glare (AG) coating layer, or the like.

As illustrated in FIG. 2, transparent adhesive layers 241 and 242 may be between the display panel 210 and the touch sensor unit 220, and between the touch sensor unit 220 and the window 300, respectively. The transparent adhesive layers 241 and 242 couple the window 300 and the display module 200 to each other. The transparent adhesive layers 241 and 242 include transparent materials, and thus may not reduce the luminance of light emitted from the display panel 210.

The light-blocking layer 321 may be on one surface of the window 300 in the non-transmissive area 320. The light-blocking layer 321 may substantially prevent the driving unit that drives the display module 200 from being externally visible.

The light-blocking layer 321 may include an organic material (e.g. an organic material having a predetermined color). Accordingly, the color of the light-blocking layer 321 may be perceived by the user in the non-transmissive area 320 of the window 300.

The light-blocking layer 321 may have various colors including black or white. In the case where the light-blocking layer 321 is black, the light-blocking layer 321 may include a black matrix. In the case where the light-blocking layer 321 is white, the light-blocking layer 321 may include an organic insulating material (e.g., a white resin). In addition, the light-blocking layer 321 may include an opaque inorganic insulating material such as CrOx or MoOx, or an opaque organic insulating material, such as a black resin. Accordingly, the light-blocking layer 321 serves to block the light inside the display module 200 to thereby hide an internal structure of the display module 200, and to determine the color of the window 300.

The light-blocking layer 321 may be formed by printing a printing composition on a base film, and by attaching the base film formed with the light-blocking layer 321 to the window 300. However, the method of forming the light-blocking layer 321 on the base film, and the method of attaching the resultant film to one surface of the window 300, may apply various methods known in the art.

The light-blocking layer 321 may have a single layer, but embodiments are not limited thereto. Alternatively, the light-blocking layer 321 may have a plurality of layers having a substantially same thickness, or may have a plurality of layers having different thicknesses.

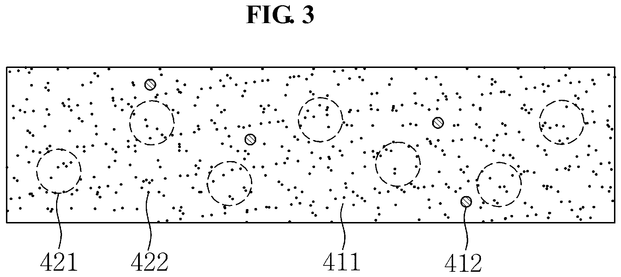

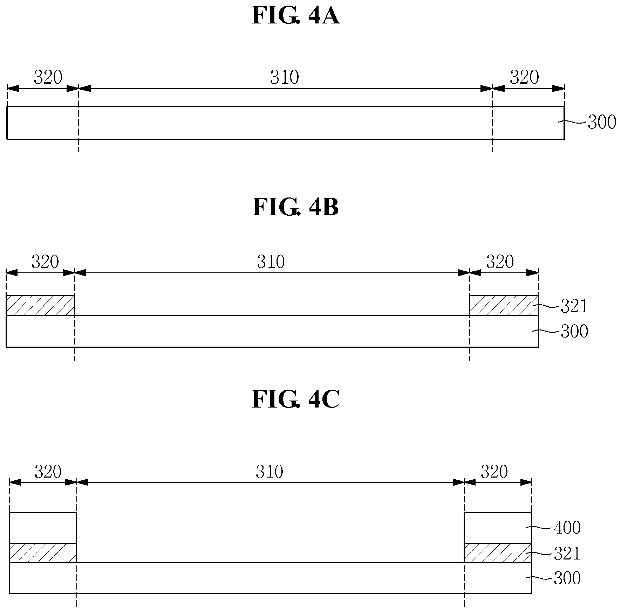

The adhesive member 400 is between the light-blocking layer 321 and the support frame 100 to couple the window 300 and the support frame 100 to each other. The adhesive member 400 will be described in detail below with reference to FIGS. 3 and 4A-4C.

FIG. 3 is a cross-sectional view illustrating an adhesive member according to an embodiment. Hereinafter, the adhesive member according to an embodiment will be described in detail with reference to FIG. 3.

The adhesive member 400 includes an adhesive polymer matrix, a ruptured shell structure 421, and an exothermic curing agent 422, as illustrated in FIG. 3.

The adhesive polymer matrix may include an adhesive polymer resin 411 and a curing accelerator 412. The adhesive polymer resin 411 has adhesiveness, and may include a polymer resin that may be cured by light or heat.

The adhesive polymer matrix may include the curing accelerator 412 that has not been reacted with the exothermic curing agent 422. The curing accelerator 412 is a material that promotes curing of the exothermic curing agent 422. Examples of the curing accelerator 412 may include at least one selected from the group consisting of piperidine, dimethyl-piperidine, triethylenediamine, benzyl dimethylamine, 2-(dimethylaminomethyl) phenol, and 2,4,6-tri (dimethylamino methylphenol). The curing accelerator 412 generates heat by reacting with the exothermic curing agent 422, as described below.

The adhesive polymer matrix may further include monomers. The monomer may be polymerized into a polymer by reaction of the exothermic curing agent 422 and the curing accelerator 412, and monomers not experiencing such reaction may remain in the adhesive polymer matrix.

The adhesive polymer matrix may further include a pigment. The pigment may include at least one of red iron oxide, black iron oxide, yellow iron oxide, titanium dioxide, ferric ammonium ferrocyanide, and mica sunshine super golden.

The ruptured shell structure 421 is dispersed in the adhesive polymer matrix. The ruptured shell structure 421 may include at least one of a melamine resin, a urethane resin, an acrylic resin, a urethane acrylic resin, and an epoxy resin. In an embodiment, the adhesive member 400 may include a shell 420, to be described below, and the exothermic curing agent 422 accommodated in the shell 420.

The exothermic curing agent 422 causes curing of the adhesive member 400. In addition, the exothermic curing agent 422 may be dispersed in the adhesive polymer matrix in a manner similar to the ruptured shell structure 421.

The exothermic curing agent 422 may include at least one selected from the group consisting of diethylenetriamine (DETA), triethylenetetramine (TTA), tetraethylenepentamine (TEPA), diproprenediamine (DPDA), diethylaminopropylamine (DEAPA), methane diamine (MDA), isophoronediamine (IPDA), metaphenylene diamine (MPDA), diaminodiphenylmethane (DDM), and diaminodiphenylsulfone (DDS).

FIGS. 4A, 4B, and 4C are views illustrating a method of manufacturing a display device according to an embodiment. Hereinafter, a method of manufacturing a display device according to an embodiment will be described in detail below with reference to FIGS. 4A, 4B, and 4C.

Referring to FIG. 4A, a window 300 having a transmissive area 310 and a non-transmissive area 320 is disposed.

Next, referring to FIG. 4B, a light-blocking layer 321 is on one surface of the window 300 in the non-transmissive area 320. The light-blocking layer 321 may be formed by printing a printing composition on a base film, and by attaching the base film formed with the light-blocking layer 321 to the window 300. However, the method of attaching the base film to the window 300 and the method of providing the resultant film to one surface of the window 300 may apply various methods known in the art.

Subsequently, referring to FIG. 4C, an adhesive member 400 is located on the light-blocking layer 321. The window 300 on which the light-blocking layer 321 and the adhesive member 400 are located is attached, by the adhesive member 400, to a support frame 100 that accommodates a display module 200.

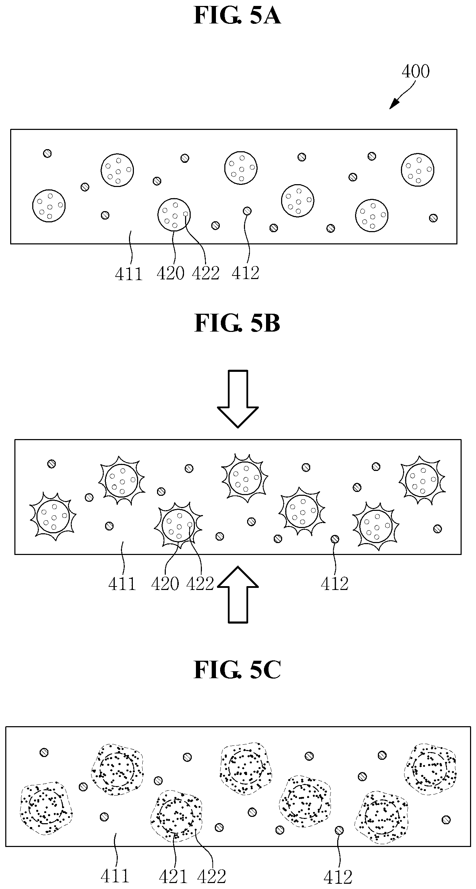

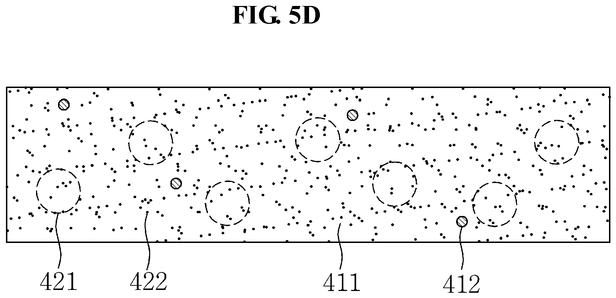

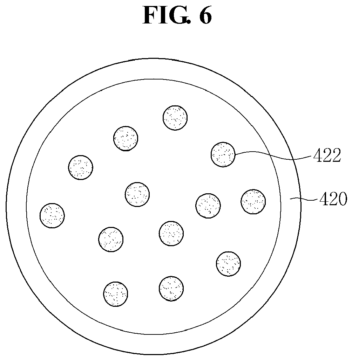

FIGS. 5A, 5B, 5C, and 5D are views illustrating a process of curing an adhesive member according to an embodiment, and FIG. 6 is a view illustrating a shell and an exothermic curing agent according to an embodiment. Hereinafter, the process of curing the adhesive member will be described in detail below with reference to FIGS. 5A, 5B, 5C, 5D, and 6.

Referring to FIG. 5A, an adhesive member 400 located between a window 300 and a support frame 100 may include, before being pressed, a shell 420 and an exothermic curing agent 422 accommodated in the shell 420. The shell 420 and the exothermic curing agent 422 are dispersed in an adhesive polymer matrix.

The shell 420 defines a space inside the shell 420, and may include at least one material selected from a melamine resin, a urethane resin, an acrylic resin, a urethane acrylic resin, and an epoxy resin. In addition, the shell 420 may have a thickness that is sufficient to define a space therein for capturing polymers such as the exothermic curing agent 422.

The exothermic curing agent 422, as illustrated in FIG. 6, may be accommodated in the inner space defined by the shell 420.

The shell 420, and the exothermic curing agent 422 accommodated in the shell 420, may be manufactured by a manufacturing method such as an interfacial polymerization method, a curing coating method, a coacervation method, and the like. For example, the shell 420 and the exothermic curing agent 422 accommodated therein may be manufactured by mixing a shell-forming material, an exothermic curing agent-forming material, and a solvent, and by stirring the mixture at a constant speed. A surfactant or the like may be used, if necessary, in the process of mixing the shell-forming material and the exothermic curing agent-forming material with the solvent. In addition, a dispersion stabilizer or the like may be used. Examples of the solvent may include water, alcohol, other known organic solvents and the like. The kind of the solvent and the surfactant varies depending on the kind of the shell-forming material and the exothermic curing agent-forming material.

A curing accelerator 412 is a material that promotes the curing of the exothermic curing agent 422. Examples of the curing accelerator 412 may include at least one selected from the group consisting of piperidine, dimethyl-piperidine, triethylenediamine, benzyl dimethylamine, 2-(dimethylaminomethyl) phenol, and 2,4,6-tri (dimethylamino methylphenol). The curing accelerator 412 generates heat by reacting with the exothermic curing agent 422.

After the window 300 is attached to the support frame 100 by the adhesive member 400, a pressure is applied to the adhesive member 400, as illustrated in FIG. 5B. For example, a pressure of about 3 kgf/m² (29,42 Pa) or more and about 10 kgf/m² (98,07 Pa) or less may be applied to the window 300 and the support frame 100. The pressure is also applied to the adhesive member 400, and accordingly, the shell 420 of the adhesive member 400 is ruptured, and the exothermic curing agent 422 accommodated in the shell 420 starts to be diffused in an adhesive polymer matrix, as illustrated in FIG. 5C. Accordingly, as illustrated in FIG. 5D, the exothermic curing agent 422 accommodated in the shell 420 is diffused substantially uniformly in the adhesive polymer matrix, and the adhesive member 400 is cured by the diffused exothermic curing agent 422. In such an embodiment, a ruptured shell structure 421 remains in the cured adhesive member 400. In an embodiment, the shell 420 included in the adhesive member 400 may be only partially ruptured. That is, the shell 420 that has not been ruptured by pressurization and the exothermic curing agent 422 accommodated in the shell 420 may remain in the cured adhesive member 400.

The curing accelerator 412 reacts with the exothermic curing agent 422 diffused in the adhesive polymer matrix to promote curing. This process is an exothermic reaction that generates heat, thus reducing a modulus of the adhesive member 400. Accordingly, a step difference that may be formed in the light-blocking layer 321 due to the adhesive member 400 may be filled, and the defects that otherwise may be caused by bubbles may be reduced. In addition, as a temperature of the adhesive member 400 rises by the exothermic reaction, the adhesive force of the adhesive member 400 may be improved. Accordingly, an area of the adhesive member 400 may be reduced, thereby reducing the non-transmissive area 320.

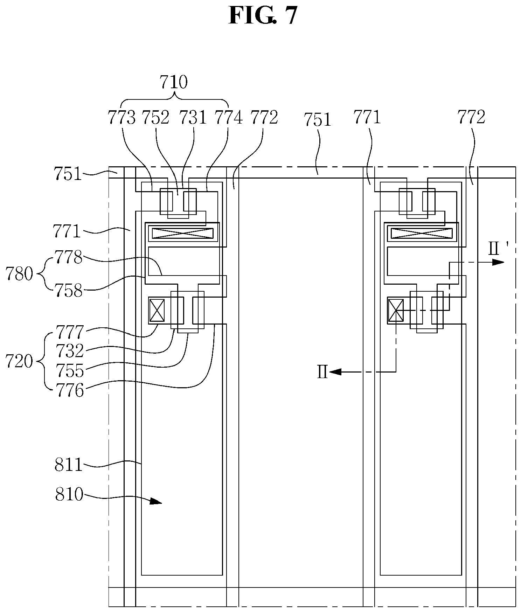

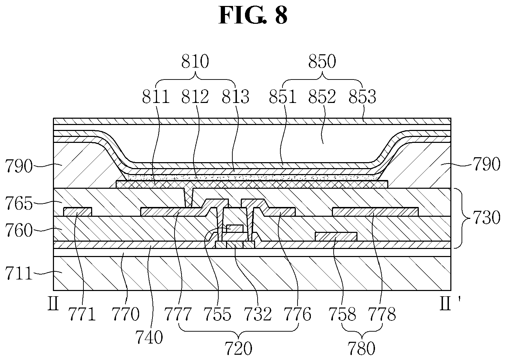

FIG. 7 is a plan view illustrating an OLED display panel according to an alternative embodiment, and FIG. 8 is a cross-sectional view taken along the line II-II' of FIG. 7.

An OLED display panel according to an alternative embodiment includes a substrate 711, a wiring portion 730, and an OLED 810.

The substrate 711 may include an insulating material selected from the group consisting of glass, quartz, ceramics, plastic, and the like. In addition, a polymer film may be used for the substrate 711.

A buffer layer 770 is on the substrate 711. The buffer layer 770 may include one or more layers selected from various inorganic layers and organic layers. The buffer layer 770 may be omitted.

The wiring portion 730 is on the buffer layer 770. The wiring portion 730 includes a plurality of thin film transistors 710 and 720, and drives the OLED 810. That is, the OLED 810 emits light in accordance with a driving signal received from the wiring portion 730 to display an image.

FIGS. 7 and 8 illustrate an active matrix-type organic light emitting diode (AMOLED) display panel having a 2Tr-1 Cap structure. For example, the 2Tr-1Cap structure may include two TFTs (e.g., the switching TFT 710 and the driving TFT 720) and one capacitor 780 in each pixel, but embodiments are not limited thereto. For example, the OLED display panel may include three or more TFTs and two or more capacitors in each pixel, and may further include additional wirings. Herein, the term "pixel" refers to a smallest unit for displaying an image, and the OLED display panel displays an image using a plurality of pixels.

Each pixel PX includes the switching TFT 710, the driving TFT 720, the capacitor 780, and the OLED 810. In addition, a gate line 751 extending along one direction, and a data line 771 and a common power line 772 insulated from, and crossing, the gate line 751 are also provided at the wiring portion 730. Each pixel PX may be defined by the gate line 751, the data line 771, and the common power line 772 as a boundary, but embodiments are not limited thereto. The pixels PX may be defined by a pixel defining layer or a black matrix.

The capacitor 780 includes a pair of capacitor plates 758 and 778, having an insulating interlayer 760 interposed therebetween. In such an embodiment, the insulating interlayer 760 may be a dielectric element. A capacitance of the capacitor 780 is determined based on electric charges accumulated in the capacitor 780, and based on a voltage across the pair of capacitor plates 758 and 778.

The switching TFT 710 includes a switching semiconductor layer 731, a switching gate electrode 752, a switching source electrode 773, and a switching drain electrode 774. The driving TFT 720 includes a driving semiconductor layer 732, a driving gate electrode 755, a driving source electrode 776, and a driving drain electrode 777. A gate insulating layer 740 is further provided to respectively insulate the semiconductor layers 731 and 732 and the gate electrodes 752 and 755.

The switching TFT 710 may function as a switching element that selects a pixel to perform light emission. The switching gate electrode 752 is connected to the gate line 751, and the switching source electrode 773 is connected to the data line 771. Spaced apart from the switching source electrode 773, the switching drain electrode 774 is connected to one of the capacitor plates (e.g., the capacitor plate 758).

The driving TFT 720 applies a driving power, which allows a light emitting layer 812 of an OLED 810 in a selected pixel to emit light, to a first electrode 811 that is a pixel electrode. The driving gate electrode 755 is connected to said one capacitor plate 758 that is connected to the switching drain electrode 774. Each of the driving source electrode 776 and the other of the capacitor plates (e.g., the capacitor plate 778), is connected to the common power line 772. The driving drain electrode 777 is connected to the first electrode 811 of the OLED 810 through a contact hole.

With the above-described structure, the switching TFT 710 is driven based on a gate voltage applied to the gate line 751, and serves to transmit a data voltage, which is applied to the data line 771, to the driving TFT 720. A voltage equivalent to a difference between a common voltage applied to the driving TFT 720 from the common power line 772 and the data voltage transmitted by (or from) the switching TFT 710 is stored in the capacitor 780, and a current corresponding to the voltage stored in the capacitor 780 flows to the OLED 810 through the driving TFT 720 such that the OLED 810 may emit light.

The OLED 810 includes the first electrode 811, the light emitting layer 812 on the first electrode 811, and a second electrode 813 on the light emitting layer 812. The light emitting layer 812 may include a low molecular weight organic material and a high molecular weight organic material. Holes and electrons are injected into the light emitting layer 812 from the first electrode 811 and the second electrode 813, respectively, to be combined with each other to form an exciton. When the excitons fall from an excited state to a ground state, light emission occurs.

Referring to FIG. 8, the first electrode 811 is an anode. The first electrode 811 may be a light transmissive electrode having light transmittance, or may be a reflective electrode having light reflectivity.

The second electrode 813 may be formed into a semi-light transmissive layer or a reflective layer.

At least one of a hole injection layer and a hole transport layer may further be provided between the first electrode 811 and the light emitting layer 812, and at least one of an electron transport layer and an electron injection layer may further be provided between the light emitting layer 812 and the second electrode 813. The light emitting layer 812, the hole injection layer the hole transport layer the electron transport layer, and the electron injection layer may include an organic material, and thus may be referred to as an organic layer.

The pixel defining layer 790 has an opening. The opening of the pixel defining layer 790 exposes a portion of the first electrode 811. The light emitting layer 812 and the second electrode 813 are sequentially stacked on the first electrode 811 in the opening of the pixel defining layer 790. Herein, the second electrode 813 is formed on the pixel defining layer 790 as well as on the light emitting layer 812. In an embodiment, the hole injection layer, the hole transporting layer, the electron transporting layer, and the electron injection layer may also be between the pixel defining layer 790 and the second electrode 813. The OLED 810 generates light from the light emitting layer 812 positioned in the opening of the pixel defining layer 790. In such a manner, the pixel defining layer 790 may define a light emitting area.

Referring to FIG. 8, a thin film encapsulation layer 850 is on the second electrode 813.

The thin film encapsulation layer 850 includes one or more inorganic layers 851 and 853 and one or more organic layers 852, and serves to prevent or reduce external air, such as moisture or oxygen, from penetrating into the OLED 810.

The thin film encapsulation layer 850 has a structure in which the inorganic layer 851 and 853 and the one organic layer 852 are alternately stacked. In FIG. 8, it is depicted that the thin film encapsulation layer 850 includes two inorganic layers 851 and 853 and one organic layer 852, but the structure of the thin film encapsulation layer 850 is not limited thereto.

The inorganic layers 851 and 853 may include one or more inorganic materials of: Al₂O₃, TiO₂, ZrO, SiO₂, AlON, AlN, SiON, Si₃N₄, ZnO and Ta₂O₅. The inorganic layers 851 and 853 may be formed through methods such as a chemical vapor deposition (CVD) method or an atomic layer deposition (ALD) method. However, embodiments are not necessarily limited thereto, and the inorganic layers 851 and 853 may be formed using various methods known to those skilled in the art.

The organic layer 852 may include a polymer-based material. Examples of the polymer-based material may include, for example, an acrylic resin, an epoxy resin, polyimide and polyethylene. In addition, the organic layer 852 may be formed through a thermal deposition process. The thermal deposition process for forming the organic layer 852 may be performed in a temperature range that may not damage the OLED 810. However, embodiments are not limited thereto, and the organic layer 852 may be formed using various methods known to those skilled in the pertinent art.

The inorganic layers 851 and 853, which have a high density thin layer, may substantially prevent or efficiently reduce infiltration of, mostly, moisture or oxygen. Permeation of moisture and oxygen into the OLED 810 may be largely reduced or prevented by the inorganic layers 851 and 853.

Moisture and oxygen that have passed through the inorganic layers 851 and/or 853 may further be blocked by the organic layer 852. The organic layer 852 has less moisture permeation prevention efficiency than the inorganic layers 851 and 853. However, the organic layer 852 may also serve as a buffer layer to reduce stress between respective ones of the inorganic layers 851 and 853, in addition to the moisture permeation prevention function. Further, because the organic layer 852 has planarization characteristics, an uppermost surface of the thin film encapsulation layer 850 may be planarized by the organic layer 852.

The thin film encapsulation layer 850 may have a thickness that is less than or equal to about 10 µm. Accordingly, the OLED display panel may also have a relatively small thickness. As such an OLED display panel may have flexible characteristics by applying the thin film encapsulation layer 850.

An encapsulation substrate may be on the second electrode 813 instead of the thin film encapsulation layer 850.

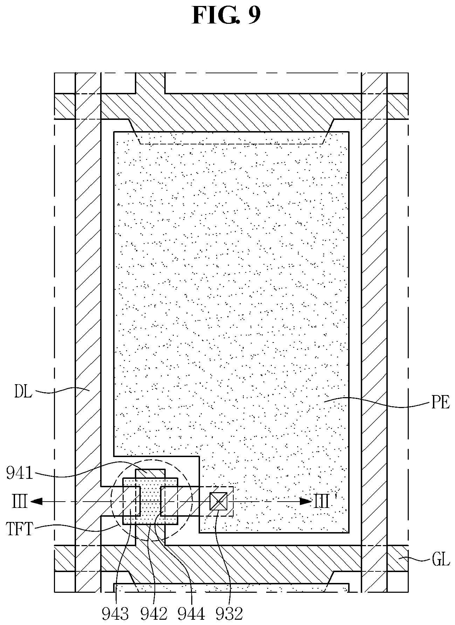

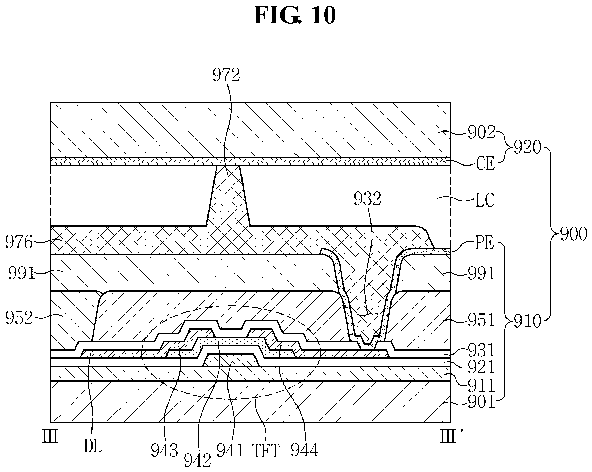

FIG. 9 is a plan view illustrating a pixel of a liquid crystal display ("LCD") device according to another alternative embodiment, and FIG. 10 is a cross-sectional view taken along the line III-III' of FIG. 9.

An LCD panel 900 includes a display substrate 910, an opposing substrate 920, and a liquid crystal layer LC, as illustrated in FIG. 10.

The display substrate 910 includes a substrate 901, an insulating layer 911 on the substrate 901, a gate line GL on the insulating layer 911, a data line DL, a thin film transistor TFT, a gate insulating layer 921, an insulating interlayer 931, color filters 951 and 952, a planarization layer 991, and a pixel electrode PE.

The gate line GL and a gate electrode 941 extending from the gate line GL are on the insulating layer 911. The gate line GL and the gate electrode 941 are on a substantially same layer.

The gate line GL and the gate electrode 941 may include, or may be formed of, one of aluminum (Al) or alloys thereof, silver (Ag) or alloys thereof, copper (Cu) or alloys thereof, or molybdenum (Mo) or alloys thereof. Alternatively, the gate line GL and the gate electrode 941 may include, or may be formed of, one of chromium (Cr), tantalum (Ta), and/or titanium (Ti). In an embodiment, the gate line GL and the gate electrode 941 may have a multilayer structure including at least two conductive layers that have different physical properties.

The gate insulating layer 921 is on the gate line GL and the gate electrode 941. In such an embodiment, the gate insulating layer 921 may be positioned on an entire surface of the substrate 901 including the gate line GL and the gate electrode 941. The gate insulating layer 921 may include, or may be formed of, silicon nitride (SiNx) or silicon oxide (SiOx). The gate insulating layer 921 may have a multilayer structure including at least two insulating layers having different physical properties.

The semiconductor layer 942 is on the gate insulating layer 921. The semiconductor layer 942 overlaps the gate electrode 941, a source electrode 943, and a drain electrode 944. The semiconductor layer 942 may include amorphous silicon, polycrystalline silicon, or the like. The semiconductor layer 942 may include an oxide semiconductor material. An ohmic contact layer may be on the semiconductor layer 942.

The data line DL is located on the gate insulating layer 921 and crosses the gate line GL.

The source electrode 943 partially overlaps the semiconductor layer 942. The source electrode 943 extends from the data line DL. For example, as illustrated in FIG. 9, the source electrode 943 has a shape protruding from the data line DL toward the gate electrode 941.

The source electrode 943 may include, or may be formed of, a refractory metal, such as molybdenum, chromium, tantalum, titanium, and/or an alloy thereof. The source electrode 943 may have a multilayer structure including a refractory metal layer and a low-resistance conductive layer. Examples of the multilayer structure may include: a double-layer structure including a chromium or molybdenum (alloy) lower layer and an aluminum (alloy) upper layer; or a triple-layer structure including a molybdenum (alloy) lower layer, an aluminum (alloy) intermediate layer, and a molybdenum (alloy) upper layer. In an alternative embodiment, the source electrode 943 may include, or may be formed of, any suitable metals and/or conductors rather than the aforementioned materials.

The drain electrode 944 partially overlaps the semiconductor layer 942, and is spaced apart from the source electrode 943 (e.g., at a predetermined distance). The drain electrode 944 is connected to the pixel electrode PE. The drain electrode 944 and the source electrode 943 may be formed concurrently or simultaneously in a substantially same process.

A thin film transistor TFT is defined by the gate electrode 941, the semiconductor layer 942, the source electrode 943, and the drain electrode 944.

A channel area of the thin film transistor TFT is positioned at a portion of the semiconductor layer 942 between the source electrode 943 and the drain electrode 944.

The insulating interlayer 931 is on the data line DL, the source electrode 943, the drain electrode 944, and the gate insulating layer 921. In such an embodiment, the insulating interlayer 931 may be located over an entire surface of the substrate 901 including the data line DL, the source electrode 943, the drain electrode 944, and the gate insulating layer 921. Referring to FIGS. 9 and 10, the insulating interlayer 931 has a drain contact hole 932. The drain electrode 944 is exposed by the drain contact hole 932.

The insulating interlayer 931 may include an inorganic insulating material, such as silicon nitride (SiNx) or silicon oxide (SiOx), or may include an organic layer. In addition, the insulating interlayer 931 may have a bilayer structure including a lower inorganic layer and an upper organic layer.

A first color filter 951 and a second color filter 952 are on the insulating interlayer 931. Edges of the first and second color filters 951 and 952 may be respectively positioned on the gate line GL, the thin film transistor TFT, and the data line DL. Edges of adjacent ones of the first and second color filters 951 and 952 may overlap each other. Each of the color filters 951 and 952 has an opening corresponding to the drain electrode 944.

The first color filter 951 and the second color filter 952 may have different colors, and may be, for example, one of a red color filter, a green color filter, a blue color filter, a cyan color filter, a magenta color filter, a yellow color filter and a white color filter.

The LCD panel 900 may further include a third color filter. The third color filter has a color that is different from those of the first color filter 951 and the second color filter 952, and may be, for example, one of a red color filter, a green color filter, a blue color filter, a cyan color filter, a magenta color filter and a yellow color filter.

Alternatively, the color filters 951 and 952 may be on a sealing substrate 902.

The planarization layer 991 is on the color filters 951 and 952. In such an embodiment, the planarization layer 991 may be located over an entire surface of the substrate 901 including the color filters 951 and 952 and the insulating interlayer 931. The planarization layer 991 may have an opening defined corresponding to the drain contact hole 932.

The planarization layer 991 functions as a protective layer and serves to planarize a portion below the pixel electrode PE. The planarization layer 991 may be referred to as a protective layer. The planarization layer 991 may include an organic material, for example, a photosensitive organic material or a photosensitive resin composition. In such an embodiment, the planarization layer 991 may be also referred to as an organic layer.

The pixel electrode PE is connected to the drain electrode 944 through the drain contact hole 932. The pixel electrode PE is on the planarization layer 991. A part of an edge of the pixel electrode PE may overlap a light-blocking portion 976.

The light-blocking portion 976 is on the pixel electrode PE and the planarization layer 991. For example, the light-blocking portion 976 overlaps the TFT, the gate lines GL, and the data line DL to block light leakage.

A column spacer 972 may be positioned on the light-blocking portion 976. The column spacer 972 has a shape protruding from the light-blocking portion 976 toward the opposing substrate 920 (e.g. extending to a predetermined height). The column spacer 972 maintains a cell gap between the display substrate 910 and the opposing substrate 920.

The column spacer 972 and the light-blocking portion 976 may be unitary (e.g., in a monolithic structure). In such an embodiment, the column spacer 972 and the light-blocking portion 976 may be substantially simultaneously manufactured using a substantially same material. Such a column spacer 972 and light-blocking portion 976 may be collectively referred to as a black column spacer (BCS).

The opposing substrate 920 includes the sealing substrate 902, and a common electrode CE on the sealing substrate 902.

The liquid crystal layer LC is on the pixel electrode PE. That is, the liquid crystal layer LC is between the substrate 901 and the sealing substrate 902. For example, the liquid crystal layer LC may be positioned in a space defined by the display substrate 910 and the opposing substrate 920.

As set forth hereinabove, the display device and the method of manufacturing the display device according to one or more embodiments may provide the following effects. The adhesive member may be cured by an exothermic reaction such that the modulus of the adhesive member may be reduced, and such that the step difference may be filled to reduce bubbles. In addition, the instantaneous adhesive force of the adhesive member may be improved by the exothermic reaction, and accordingly, an adhesive area may be reduced as compared with the conventional display device.

While embodiments of the present invention have been illustrated and described with reference to the embodiments thereof, it will be apparent to those of ordinary skill in the art that various changes in form and detail may be formed thereto without departing from the scope of the present invention as set forth in the following claims.

## Claims

1. A display device comprising:
a support frame (100) having an accommodation space;
a display module (200) in the accommodation space;
a window (300) on the display module (200), and having a transmissive area (310) and a non-transmissive area (320);
a light-blocking layer (321) at the non-transmissive area (320) of the window (300); and
an adhesive member (400) between the light-blocking layer (321) and the support frame (100),
wherein the window (300) is attached to the support frame (100) by the adhesive member (400)
**characterized in that**
the adhesive member (400) comprises:
an adhesive polymer matrix;
a ruptured shell structure (421); and
an exothermic curing agent (422),
wherein the adhesive polymer matrix comprises an adhesive polymer resin (411), a monomer, and a curing accelerator (412).

2. The display device as claimed in claim 1, wherein the ruptured shell structure (421) comprises at least one of a melamine resin, a urethane resin, an acrylic resin, a urethane acrylic resin, and an epoxy resin.

3. The display device as claimed in claim 1 or 2, wherein the exothermic curing agent (422) comprises at least one of diethylenetriamine (DETA), triethylenetetramine (TTA), tetraethylenepentamine (TEPA), diproprenediamine (DPDA), diethylaminopropylamine (DEAPA), methane diamine (MDA), isophoronediamine (IPDA), metaphenylene diamine (MPDA), diaminodiphenylmethane (DDM), and diaminodiphenylsulfone (DDS).

4. The display device as claimed in claim 1, wherein the curing accelerator (412) comprises at least one of piperidine, dimethyl-piperidine, triethylenediamine, benzyl dimethylamine, 2-(dimethyl aminomethyl) phenol, and 2,4,6-tri (dimethylamino methylphenol).

5. The display device as claimed in at least one of claims 1 to 4, wherein the adhesive member (400) further comprises a shell (420), and wherein the exothermic curing agent (422) is accommodated in the shell (420).

6. The display device as claimed in at least one of claims 1 to 5, wherein the display module (200) comprises a display panel (210).

7. The display device as claimed in claim 6, wherein the display panel (210) comprises:
a first substrate (910);
a second substrate (920) opposing the first substrate (910); and
a liquid crystal layer (LC) between the first substrate (910) and the second substrate (920).

8. The display device as claimed in claim 6, wherein the display panel (210) comprises
a first substrate (711);
a first electrode (811) on the first substrate (711);
an organic light emitting layer (812) on the first electrode (811); and
a second electrode (813) on the organic light emitting layer (812).

9. The display device as claimed in at least one of claims 6 to 8, wherein the display module (200) comprises a touch sensor unit (220) on the display panel (210).

10. A method of manufacturing a display device, the method comprising
disposing a light-blocking layer (321) on one surface of a window (300) having a transmissive area (310) and a non-transmissive area (320);
disposing an adhesive member (400) on the light-blocking layer (321);
attaching the window (300), on which the adhesive member (400) is disposed, and a support frame (100) accommodating a display module (200); and
applying a pressure to the window (300) and the support frame (100) **characterized by**
the adhesive member (400) comprising:
an adhesive polymer matrix;
a shell (420) dispersed in the adhesive polymer matrix; and
an exothermic curing agent (422) accommodated in the shell (420),
wherein the adhesive polymer matrix comprises an adhesive polymer resin (411), a monomer, and a curing accelerator (412).

11. The method as claimed in claim 10, wherein the shell (420) comprises at least one of diethylenetriamine (DETA), triethylenetetramine (TTA), tetraethylenepentamine (TEPA), diproprenediamine (DPDA), diethylaminopropylamine (DEAPA), methane diamine (MDA), isophoronediamine (IPDA), metaphenylene diamine (MPDA), diaminodiphenylmethane (DDM) and diaminodiphenylsulfone (DDS).

12. The method as claimed in at least one of claims 10 to 11, wherein the pressure is in a range from about 29,42 Pa to about 98,07 Pa.

13. The method as claimed in at least one of claims 10 to 12, further comprising rupturing the shell (420) by the pressure.

## Patentansprüche

1. Anzeigevorrichtung, umfassend:
einen Halterahmen (100), der einen Aufnahmeraum aufweist;
ein Anzeigemodul (200) in dem Aufnahmeraum;
ein Fenster (300), das sich auf dem Anzeigemodul (200) befindet und einen durchlässigen Bereich (310) und einen undurchlässigen Bereich (320) aufweist;
eine lichtblockierende Schicht (321) in dem undurchlässigen Bereich (320) des Fensters (300); und
ein Klebeelement (400) zwischen der lichtblockierenden Schicht (321) und dem Halterahmen (100),
wobei das Fenster (300) durch das Klebeelement (400) an dem Halterahmen (100) befestigt ist,
**dadurch gekennzeichnet, dass**
das Klebeelement (400) Folgendes umfasst:
eine klebende Polymermatrix;
eine zerbrochene Hüllenstruktur (421); und
ein exothermes Härtungsmittel (422),
wobei die klebende Polymermatrix ein klebendes Polymerharz (411), ein Monomer und einen Härtungsbeschleuniger (412) umfasst.

2. Anzeigevorrichtung nach Anspruch 1, wobei die zerbrochene Hüllenstruktur (421) wenigstens eines aus einem Melaminharz, einem Urethanharz, einem Acrylharz, einem Urethanacrylharz und einem Epoxidharz umfasst.

3. Anzeigevorrichtung nach Anspruch 1 oder 2, wobei das exotherme Härtungsmittel (422) wenigstens eines aus Diethylentriamin (DETA), Triethylentetramin (TTA), Tetraethylenpentamin (TEPA), Diproprendiamin (DPDA), Diethylaminopropylamin (DEAPA), Methandiamin (MDA), Isophorondiamin (IPDA), Metaphenylendiamin (MPDA), Diaminodiphenylmethan (DDM) und Diaminodiphenylsulfon (DDS) umfasst.

4. Anzeigevorrichtung nach Anspruch 1, wobei der Härtungsbeschleuniger (412) wenigstens eines aus Piperidin, Dimethylpiperidin, Triethylendiamin, Benzyldimethylamin, 2-(Dimethylaminomethyl)phenol und 2,4,6-Tri-(dimethylaminomethylphenol) umfasst.

5. Anzeigevorrichtung nach wenigstens einem der Ansprüche 1 bis 4, wobei das Klebeelement (400) ferner eine Hülle (420) umfasst und wobei das exotherme Härtungsmittel (422) in der Hülle (420) aufgenommen ist.

6. Anzeigevorrichtung nach wenigstens einem der Ansprüche 1 bis 5, wobei das Anzeigemodul (200) ein Anzeigefeld (210) umfasst.

7. Anzeigevorrichtung nach Anspruch 6, wobei das Anzeigefeld (210) Folgendes umfasst:
ein erstes Substrat (910);
ein zweites Substrat (920), das dem ersten Substrat (910) gegenüberliegt; und
eine Flüssigkristallschicht (LC) zwischen dem ersten Substrat (910) und dem zweiten Substrat (920).

8. Anzeigevorrichtung nach Anspruch 6, wobei das Anzeigefeld (210) Folgendes umfasst:
ein erstes Substrat (711);
eine erste Elektrode (811) auf dem ersten Substrat (711);
eine organische lichtemittierende Schicht (812) auf der ersten Elektrode (811);
und
eine zweite Elektrode (813) auf der organischen lichtemittierenden Schicht (812).

9. Anzeigevorrichtung nach wenigstens einem der Ansprüche 6 bis 8, wobei das Anzeigemodul (200) eine Berührungssensoreinheit (220) auf dem Anzeigefeld (210) umfasst.

10. Verfahren zur Herstellung einer Anzeigevorrichtung, wobei das Verfahren Folgendes umfasst:
Anordnen einer lichtblockierenden Schicht (321) auf einer Oberfläche eines Fensters (300), das einen durchlässigen Bereich (310) und einen undurchlässigen Bereich (320) aufweist;
Anordnen eines Klebeelements (400) auf der lichtblockierenden Schicht (321);
Befestigen des Fensters (300), auf dem das Klebeelement (400) angeordnet ist,
und eines Halterahmens (100), der ein Anzeigemodul (200) aufnimmt; und
Anlegen eines Drucks auf das Fenster (300) und den Halterahmen (100),
**gekennzeichnet durch**
das Klebeelement (400), das Folgendes umfasst:
eine klebende Polymermatrix;
eine Hülle (420), die in der klebenden Polymermatrix verteilt ist; und
ein exothermes Härtungsmittel (422), das in der Hülle (420) aufgenommen ist,
wobei die klebende Polymermatrix ein klebendes Polymerharz (411), ein Monomer und einen Härtungsbeschleuniger (412) umfasst.

11. Verfahren nach Anspruch 10, wobei die Hülle (420) wenigstens eines aus Diethylentriamin (DETA), Triethylentetramin (TTA), Tetraethylenpentamin (TEPA), Diproprendiamin (DPDA), Diethylaminopropylamin (DEAPA), Methandiamin (MDA), Isophorondiamin (IPDA), Metaphenylendiamin (MPDA), Diaminodiphenylmethan (DDM) und Diaminodiphenylsulfon (DDS) umfasst.

12. Verfahren nach wenigstens einem der Ansprüche 10 bis 11, wobei der Druck in einem Bereich von etwa 29,42 Pa bis etwa 98,07 Pa liegt.

13. Verfahren nach wenigstens einem der Ansprüche 10 bis 12, ferner umfassend das Zerbrechen der Hülle (420) durch den Druck.

## Revendications

1. Dispositif d'affichage comprenant :
un cadre de support (100) ayant un espace de logement ;
un module d'affichage (200) dans l'espace de logement ;
une fenêtre (300) sur le module d'affichage (200), et ayant une zone transmissive (310) et une zone non transmissive (320) ;
une couche de blocage de lumière (321) au niveau de la zone non transmissive (320) de la fenêtre (300) ; et
un organe adhésif (400) entre la couche de blocage de lumière (321) et le cadre de support (100),
dans lequel la fenêtre (300) est fixée au cadre de support (100) par l'organe adhésif (400)
**caractérisé en ce que**
l'organe adhésif (400) comprend :
une matrice de polymère adhésif ;
une structure à enveloppe rompue (421) ; et
un agent de durcissement exothermique (422),
dans lequel la matrice de polymère adhésif comprend une résine de polymère adhésif (411), un monomère, et un accélérateur de durcissement (412).

2. Dispositif d'affichage selon la revendication 1, dans lequel la structure à enveloppe rompue (421) comprend au moins l'une parmi une résine de mélamine, une résine uréthane, une résine acrylique, une résine acrylique uréthane, et une résine époxy.

3. Dispositif d'affichage selon la revendication 1 ou 2, dans lequel l'agent de durcissement exothermique (422) comprend au moins l'une parmi la diéthylènetriamine (DETA), la triéthylènetétramine (TTA), la tétraéthylènepentamine (TEPA), la diproprènediamine (DPDA), la diéthylaminopropylamine (DEAPA), la méthane diamine (MDA), l'isophoronediamine (IPDA), la métaphénylène diamine (MPDA), le diaminodiphénylméthane (DDM), et la diaminodiphénylsulfone (DDS).

4. Dispositif d'affichage selon la revendication 1, dans lequel l'accélérateur de durcissement (412) comprend au moins l'une parmi la pipéridine, la diméthyl-pipéridine, la triéthylènediamine, la benzyl diméthylamine, le 2-(diméthyl aminométhyl) phénol, et le 2,4,6-tri (diméthylamino méthylphénol).

5. Dispositif d'affichage selon au moins l'une des revendications 1 à 4, dans lequel l'organe adhésif (400) comprend en outre une enveloppe (420), et dans lequel l'agent de durcissement exothermique (422) est logé dans l'enveloppe (420).

6. Dispositif d'affichage selon au moins l'une des revendications 1 à 5, dans lequel le module d'affichage (200) comprend un panneau d'affichage (210).

7. Dispositif d'affichage selon la revendication 6, dans lequel le panneau d'affichage (210) comprend :
un premier substrat (910) ;
un second substrat (920) opposé au premier substrat (910) ; et
une couche de cristaux liquides (LC) entre le premier substrat (910) et le second substrat (920).

8. Dispositif d'affichage selon la revendication 6, dans lequel le panneau d'affichage (210) comprend
un premier substrat (711) ;
une première électrode (811) sur le premier substrat (711) ;
une couche électroluminescente organique (812) sur la première électrode (811) ; et
une seconde électrode (813) sur la couche électroluminescente organique (812).

9. Dispositif d'affichage selon au moins l'une des revendications 6 à 8, dans lequel le module d'affichage (200) comprend une unité de capteur tactile (220) sur le panneau d'affichage (210).

10. Procédé de fabrication d'un dispositif d'affichage, le procédé comprenant
la disposition d'une couche de blocage de lumière (321) sur une surface d'une fenêtre (300) ayant une zone transmissive (310) et une zone non transmissive (320) ;
la disposition d'un organe adhésif (400) sur la couche de blocage de lumière (321) ;
la fixation de la fenêtre (300), sur laquelle l'organe adhésif (400) est disposé, et d'un cadre de support (100) logeant un module d'affichage (200) ; et l'application d'une pression à la fenêtre (300) et au cadre de support (100), **caractérisé en ce que**
l'organe adhésif (400) comprend :
une matrice de polymère adhésif ;
une enveloppe (420) dispersée dans la matrice de polymère adhésif ; et
un agent de durcissement exothermique (422) logé dans l'enveloppe (420),
dans lequel la matrice de polymère adhésif comprend une résine de polymère adhésif (411), un monomère, et un accélérateur de durcissement (412).

11. Procédé selon la revendication 10, dans lequel l'enveloppe (420) comprend au moins l'une parmi la diéthylènetriamine (DETA), la triéthylènetétramine (TTA), la tétraéthylènepentamine (TEPA), la diproprènediamine (DPDA), la diéthylaminopropylamine (DEAPA), la méthane diamine (MDA), l'isophoronediamine (IPDA), la métaphénylène diamine (MPDA), le diaminodiphénylméthane (DDM) et la diaminodiphénylsulfone (DDS).

12. Procédé selon au moins l'une des revendications 10 et 11, dans lequel la pression est dans une plage d'environ 29,42 Pa à environ 98,07 Pa.

13. Procédé selon au moins l'une des revendications 10 à 12, comprenant en outre la rupture de l'enveloppe (420) par la pression.
